Europäisches Patentamt

European Patent Office

Office européen des brevets

(11) Publication number: **0 434 298 A1**

# (12) EUROPEAN PATENT APPLICATION

(21) Application number: 90313539.0

(22) Date of filing: **12.12.90**

(51) Int. Cl.5: **H05K 7/20**

(30) Priority: **21.12.89 US 454655**

(43) Date of publication of application:
**26.06.91 Bulletin 91/26**

(84) Designated Contracting States:
**DE FR GB**

(71) Applicant: **International Business Machines Corporation**
**Old Orchard Road**
**Armonk, N.Y. 10504(US)**

(72) Inventor: **Buller, Marvin Lawrence**
**3114 Thousand Oaks Drive**
**Austin, Texas 78746(US)**
Inventor: **McNelis, Barbara Jean**
**2000 Augusta Drive**
**Houston, Texas 77057(US)**
Inventor: **Snyder, Campbell Hodges**
**1512 West 31st Street**
**Austin, Texas 78703(US)**

(74) Representative: **Bailey, Geoffrey Alan**
**IBM United Kingdom Limited Intellectual Property Department Hursley Park**
**Winchester Hampshire SO21 2JN(GB)**

(54) **Thermally enhanced electronic component package.**

(57) An electronic component package comprises an electronic component module on which is mounted a heat sink (18). Raised integral portions (20) of the module prevent unwanted movement of the heat sink. In one embodiment the heat sink is held in thermal contact with the module by means of interfacially disposed thermally conductive adhesive material (14). In another embodiment the heat sink is held in thermal contact by co-operable detent means (30,34) provided between the heat sink and the raised integral edge portions of the module.

FIG. 3

# THERMALLY ENHANCED ELECTRONIC COMPONENT PACKAGE

This invention relates to cooling integrated circuit chip packages and more particularly it relates to improved convective cooling of high power devices in moulded plastic packages. Such circuit chip packages find particular use in electronic circuits.

Various heat sinking configurations for the enhancement of integrated circuit chip packages are known. In many instances, additional spring clamps are used to assist in the assembly of the heat sink to the circuit package. Clamps require additional parts with their associated costs and increased handling and inventory. A spring/clamp attach technique also fails to reduce potential thermal interface problems which may occur when two non-flat surfaces are mated together. This interface mismatch increases the thermal resistance to heat flow and, thus, reduces the amount of power that can be dissipated by the assembled heat sink.

Available techniques to reduce the above noted interface thermal resistance problem include the utilization of a material such as a thermal grease or a thermal epoxy between the circuit package and the thermal enhancement (heat sink).

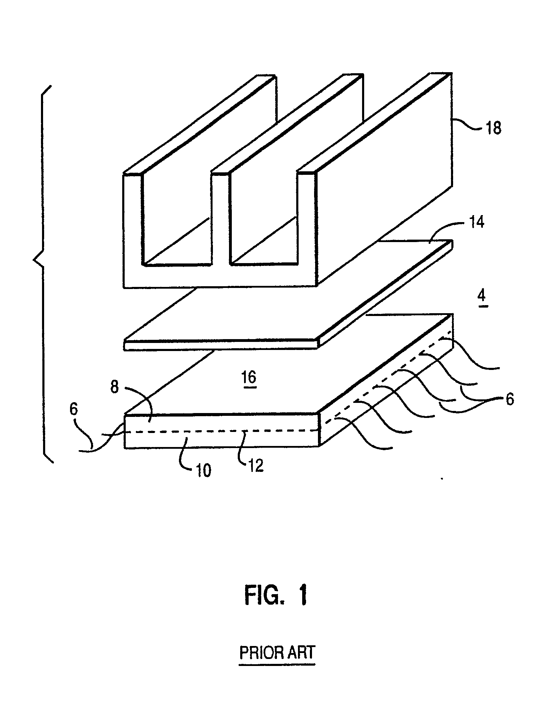

Fig. 1 exemplifies conventional surface mount plastic package heat sinks. A leaded component (not visible) is packaged in moulded plastic housing 4, also known as a flat pack or module. Component leads 6 extend from housing 4, which is typically formed by joining two separately moulded members 8 and 10 at the interface indicated by dotted line 12.

Interface material 14, such as thermal glue or epoxy, is sized to conform to the upper planar surface 16 of housing 4. An extruded finned heat sink 18 is retained in heat conducting relation to component housing 4 by interface material 14.

One difficulty with such a thermal enhancement technique is the attendant requirement for special tooling to accurately align and orient the heat sink and interface material with respect to the component during epoxy curing operation(s) in order to avoid any misalignment which would have a negative impact on efficient utilization of the thermal enhancement.

Further, epoxy is difficult to handle in a rework environment since it forms a strong bond, the breaking of which increases the chances of damage to the assembly.

Some of these problems may be solved with the use of a non-curing thermal grease as the interface material. However, a thermal grease still must be applied to one of the two mating surfaces, and its use indices alignment problems since it does not "set". Although thermal grease is very reworkable, it is not stable. This feature implies that a slip i.e. lateral movement, could occur between the two bonded surfaces which would reduce the effectiveness of the enhancement. Thermal grease could leak out if not adequately confined; and its material properties may change with time creating a material interface not representative of initial design requirements.

Prior art heat dissipation methods are adequate so long as circuit package design and spacing constraints are such that an additional spring assembly can be incorporated into the product design. When the assembly procedure is such that a curing cycle does not add unacceptable expense in the form of additional ovens, floor space, utility consumption, material handling, etc., the use of epoxy bond is acceptable. If material stability if not a problem, then thermal grease interface techniques may be used.

IBM Technical Disclosure Bulletin, Vol. 22, No. 3, 8/79. p. 960 to DeMaine et al describes a field removable, replaceable, and reusable heat sink. Attachment of the heat sink to the module is accomplished by means of a heat of chemically shrinkable plastic collar.

IBM Technical Disclosure Bulletin, Vol. 28, No. 12, 5/86. p. 5172 to Lee et al discloses a heat sink adapted for attachment to a module with a spring clip.

IBM Technical Disclosure Bulletin, Vol. 28, No. 12, 5/86. p. 5531 to Curtis et al discloses a technique for thermally enhancing plastic packaged modules by bonding ceramic to the device lead frame prior to encapsulation.

Presently, it is desirable to use automated assembly procedures with reduced assembly operations. Included in such procedures is an additional desire to stock minimum parts. It is also a desirable feature to have a reworkable enhancement assembly technique which performs uniformly with respect to the lifetime of the circuit package. In this case prior art circuit package thermal enhancement attachment techniques are inadequate.

According to the invention, an electronic component package comprises an electronic component module having a substantially planar surface, a heat sink having a surface substantially co-extensive with the module surface and located in thermal contact therewith, the module surface being formed with raised integral edge potions arranged to abut the heat sink at least at opposite edges thereof, the construction and arrangement of the edge portions with respect to the heat sink being such as to prevent unwanted lateral movement of the heat sink over the surface of the module.

According to one embodiment of the invention the heat sink is held in thermal contact with the surface of the electronic component module by cooperable detent means provided between said heat sink and raised abutting integral edge portions respectively.

According to another embodiment of the invention the heat sink is held in thermal contact with the surface of the electronic component module by means of interfacially disposed thermally conductive adhesive material.

In order that the invention may be fully understood preferred embodiments thereof will now be described with reference to the accompanying drawings in which:

Fig. 1 is an exploded view of a conventional heat sink apparatus for surface mount plastic packages and described above;

Fig. 2 is an exploded, perspective view of a first embodiment of the invention; and

Fig. 3 is an exploded, perspective view of another embodiment of the invention.

The present invention finds particular utility with high power electronic components such as microprocessors. Currently such devices are available in plastic flatpacks or modules which are generally square.

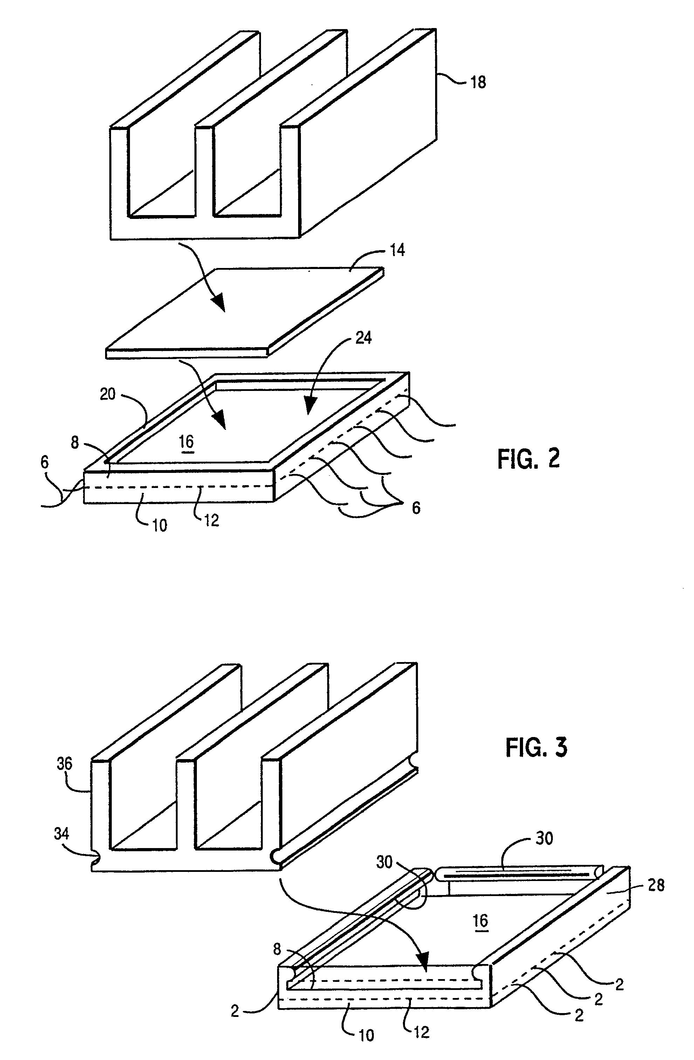

Referring now to Fig. 2, a perspective view of a plastic chip package is shown with surface 16 of its top section 8 of the module or housing modified in accordance with the invention to accept a typical heat sink 18. The modification of surface 16 shown in Fig. 2 results in a raised ridge or flange 20, around the upper perimeter of top housing section 8, which forms an indentation or cavity 24 surrounded by flange 20 on top surface 16 of the plastic package.

In operation, a plastic package provided with the surface configuration shown in Fig. 2 is assembled to a circuit card (not shown) in accordance with conventional electronic card assembly manufacturing processes. Thermally conductive interface material 14, (which may be an adhesive) sized to conform to the exposed area of surface 16 within flange 20 is placed therein, followed by heat sink 18.

Cavity 24 provides that heat sink 18 is properly oriented and aligned on the top section 8 of the module and is not subject to being dislodged during subsequent process steps. Such necessary steps may include curing interface material 14. Flange 20 further provides that heat sink 18 is placed in the same orientation as the top section of the module, substantially eliminating skewing i.e. lateral movement of the heat sink 18 by handling or vibration.

Referring now to Fig. 3, an embodiment of the invention is described which enhances assembly and rework capability. An exploded perspective view is shown with top surface 16 of the module modified by the provision of integral upwardly extending flanges 28 provided along all four edges of the module. Each flange has an inwardly extending ports 30 functioning as a clip element or detent to matingly engage with grooves 34 which have been extruded, molded or machined into the side surfaces of heat sink 36. There is no need for an interface material but such a material may be included if desired to enhance thermal contact. Proper alignment of the heat sink 36 with respect to the orientation of the top surface of the module is thus provided for. In addition, the reworkability of the package is enhanced by the ease in which the heat sink can be removed from the module and replaced at will.

The attachment technique shown in Fig. 3 increases the capability of using the same plastic chip package for various air cooled machines. By use of different heat sink designs (e.g. no. of fins, fin spacing, fin heights, etc) the same component may be enhanced for operation in other electronic systems with cooling flow rates.

Further, heat sink configuration 36, that is with only two sides thereof having grooves to engage clip 28, allows the same heat sink - plastic package combination to be used in situations with different air flow patterns and directions. Even after being rotated 90 degrees, heat sink 36 may still be snap fitted into the other pair of opposed parallel clip 28 legs.

It will be appreciated that whilst a continuous flange has been shown around the entire periphery of the module in Fig. 2 and along each edge of the module in Fig. 3 there are many alternatives that may be employed. For example, simple L-shaped corner pieces at two or more corners will serve to locate a heat sink and hold it in place. Alternatively, short side portions will serve the same purpose with only two being required if they are located on opposite sides of the module to abut opposite edges of the heat sink. In this latter case, an interference fit is preferred to prevent unwanted longitudinal movement of the heat sink between the raised edges of the module.

Electronic component circuit packaging has been described in which features are moulded into the plastic cover of a circuit module so as to readily mate with a complimentarily configured heat sink. The plastic package and heat sink may conveniently be configured during molding and/or extrusion forming steps to mate together. An interface material acting solely as a thermal contact enhancer, or additionally as an adhesive to hold the heat sink in place on the module where reworkability is not an essential feature, may be included. Where the reworkable feature is desirable a further embodiment has been described in which the heat sink and plastic package are configured to snap into mating engagement with or without an interface material therebetween. All of these packages may be assembled using automated material handling techniques.

Providing heat sink element receiving members on the package allows attachment of a heat sink yielding a thermally enhanced package, optimized for placement, orientation, attachment and assembly procedures. The present invention facilitates both greater reworkability of and improved power dissipation from the circuit chip package.

The improved, simplified attachment technique for the assembly of a reworkable convective heat sink to a circuit package has been achieved without introducing new materials and/or processes to the assembly operation. An advantage of the package is that the assembly technique is not restricted to a single convective heat sink design. Further, the assembly techniques using a raised flange as a locator for the heat sink provides a means of ensuring that the convective heat sink is correctly oriented with respect to the orientation of the circuit package and the cooling flow.

While the present invention has been described having reference to preferred embodiments and modifications thereto, those having skill in the art will appreciate that practice or our invention is not limited to the heat sink design used only for illustrative purposes. Alterations to the design of the molded change to the top surface of the plastic chip package to accommodate other heat sink designs needed to meet other cooling requirements (e.g. circular fins, pin fins, etc) and still other changes in form and detail may be made without departing from the scope of the invention.

## Claims

1.  An electronic component package comprising an electronic component module having a substantially planar surface, a heat sink having a surface substantially co-extensive with the module surface and located in thermal contact therewith, the module surface being formed with raised integral edge potions arranged to abut the heat sink at least at opposite edges thereof, the construction and arrangement of the edge portions with respect to the heat sink being such as to prevent unwanted movement of the heat sink over the surface of the module.

2.  An electronic component package as claimed in Claim 1 in which the raised integral edge potions are provided by upwardly extending flanges extending along the edges of the module surface.

3.  An electronic component package as claimed in any of Claims 1 or 2 wherein said heat sink is held in thermal contact with said surface of the electronic component module by co-operable detent means provided between said heat sink and raised abutting integral edge portions respectively.

4.  An electronic component package as claimed in Claim 3 when appended to Claim 2, in which the co-operable detent means is provided by inwardly extending portions of the flanges adapted to engage with complementary grooves around the abutting periphery of the heat sink, said flanges being of sufficient resilience to permit insertion and removal of said heat sink at will.

5.  An electronic component package as claimed in any of Claims 1 or 2 wherein said heat sink is held in thermal contact with said surface of the electronic component module by means of interfacially disposed thermally conductive adhesive material.

6.  An electronic component package as claimed in any of the preceding claims wherein said raised edge portions extend round said surface of the electronic component module to form a flange.

7.  An electronic circuit assembly including an electronic component package as claimed in any preceding claim.

## FIG. 1

PRIOR ART

FIG. 2

FIG. 3

European Patent
Office

EUROPEAN SEARCH REPORT

Application Number

EP 90313539.0

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | <u>DE - A1 - 3 611 658</u><br>(OMROR)<br>    * Abstract; fig. 1-15; claims<br>      1-18 *<br>      ---- | 1-7 | H 05 K 7/20 |
| | | | TECHNICAL FIELDS SEARCHED (Int. Cl.5) |
| | | | H 05 K 5/00<br>H 05 K 7/00 |

The present search report has been drawn up for all claims

| Place of search | Date of completion of the search | Examiner |
|---|---|---|
| VIENNA | 04-04-1991 | VAKIL |

FPO FORM 1503 03.82 (P0401)